# EUROPEAN PATENT SPECIFICATION

(11) **EP 3 262 127 B1**
(45) Date of publication and mention of the grant of the patent: **05.06.2019**
(21) Application number: 16705209.1
(22) Date of filing: 19.02.2016
(51) Int. Cl.: C09D 11/50, H01L 51/50

(54) **PHOSPHORESCENT INK**
PHOSPHORESZIERENDE TINTE
ENCRE PHOSPHORESCENTE

(30) Priority: 27.02.2015 GB 201503400
(43) Date of publication of application: 03.01.2018
(73) Proprietor: Cambridge Display Technology Limited, Cardinal Way Godmanchester Cambridgeshire PE29 2XG (GB)
(72) Inventor: ISLAM, Nazrul, Godmanchester Cambridgeshire PE29 2XG (GB); GODDARD, Simon, Godmanchester Cambridgeshire PE29 2XG (GB); GONÇALVES, Gonçalo,Pedro, Cambridge Cambridgeshire CB1 1EG (GB)
(74) Representative: Nevard, Edward John
(86) International application number: PCT/EP2016/053599
(87) International publication number: WO 2016/135064

(56) References cited:
- WO-A1-2011/087601
- WO-A1-2014/163083
- US-A1- 2007 088 167

## Description

### Background of the Invention

Electronic devices containing active organic materials are attracting increasing attention for use in devices such as organic light emitting diodes (OLEDs), organic light-emitting electrochemical cells (LECs), organic photoresponsive devices (in particular organic photovoltaic devices and organic photosensors), organic transistors and memory array devices. Devices containing active organic materials offer benefits such as low weight, low power consumption and flexibility. Moreover, use of soluble organic materials allows use of solution processing in device manufacture, for example inkjet printing, slot die coating or spin-coating.

An OLED comprises a substrate carrying an anode, a cathode and one or more organic light-emitting layers between the anode and cathode.

An organic LEC comprises a substrate carrying an anode, a cathode and an organic light-emitting layer between the anode and cathode comprising a light-emitting material, a salt providing mobile ions and an electrolyte, for example a polymer electrolyte ("polyelectrolyte"). LECs are disclosed in, for example, WO 96/00983.

Holes are injected into the device through the anode and electrons are injected through the cathode during operation of the device. Holes in the highest occupied molecular orbital (HOMO) and electrons in the lowest unoccupied molecular orbital (LUMO) of a light-emitting material combine to form an exciton that releases its energy as light. In the case of an organic LEC, the cations and anions of the salt may respectively p- and n-dope the light-emitting material, which may provide for a low drive voltage.

Suitable light-emitting materials include small molecule, polymeric and dendrimeric materials. Suitable light-emitting polymers for use in the light-emitting layer include poly(arylene vinylenes) such as poly(p-phenylene vinylenes) and polyarylenes such as polyfluorenes.

A light emitting layer may comprise a semiconducting host material and a light-emitting dopant wherein energy is transferred from the host material to the light-emitting dopant. The light-emitting dopant may be fluorescent or phosphorescent.

WO 2008/090795 discloses phosphorescent compounds of formula (1): 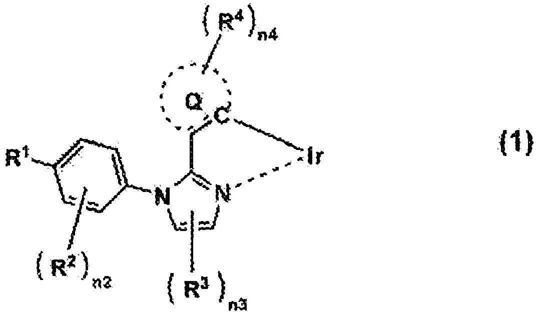 wherein R¹ represents a group; R²-R⁴ independently represent a substituent; n2 represents a number of 0-4; n4 represents a number of 0-8; and Q represents an atomic group necessary for forming an aromatic hydrocarbon ring or an aromatic heterocyclic ring.

US7659010 describes a blue light-emitting transition metal containing compound having the following formula: 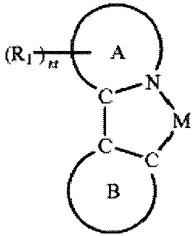 wherein A can be triazole or tetrazole, B is a five- or six-membered aryl or heteroaryl ring and M is a d-block transition metal.

EP 1083775 discloses compositions comprising a functional material and a solvent comprising at least one benzene derivative having 1 or more substituents, the substituents having 3 or more carbon atoms in total. The functional material may be an organic EL material. The composition may be used in an inkjet method.

It is an object of the invention to provide stable ink compositions comprising phosphorescent light-emitting materials.

### Summary of the Invention

In a first aspect the invention provides an ink comprising a first solvent, a stabiliser and a first phosphorescent metal complex wherein the first phosphorescent metal complex comprises at least one aryl-imidazole or heteroaryl-imidazole ligand that may be unsubstituted or substituted with one or more substituents and wherein the first solvent is selected from: linear, branched or cyclic ethers comprising one or more O-CH₂ units; solvents comprising a CH₂-C(R⁶)H-CH₂ unit wherein R⁶ is an organic residue and the two CH₂ groups may be linked by a divalent group: bicyclic, partially or fully saturated solvents; solvents of formula R⁸-CR⁷=CR⁷-CH₂- R⁸ wherein each R⁷ is independently H or C₁₋₁₀ alkyl and R⁸ in each occurrence is independently an organic residue; and solvents comprising a benzyl group.

In a second aspect the invention provides a method of forming an organic light-emitting device comprising an anode, a cathode and a light-emitting layer between the anode and cathode, the method comprising the steps of forming the light-emitting layer by depositing the ink of the first aspect over one of the anode and cathode; evaporating the solvent; and forming the other of the anode and cathode over the light-emitting layer.

In a third aspect the invention provides an ink comprising a first solvent, an antioxidant and a first phosphorescent metal complex wherein the first phosphorescent metal complex comprises at least one aryl-imidazole or heteroaryl-imidazole ligand that may be unsubstituted or substituted with one or more substituents.

The first solvent, antioxidant and first phosphorescent material may be as described anywhere herein. The ink of the third aspect may be used to form an organic light-emitting device as described with reference to the second aspect.

### Description of the Drawings

The invention will now be described in more detail with reference to the Figures, in which:
Figure 1 illustrates schematically an OLED formed according to an embodiment of the invention;
Figure 2 illustrates LCMS spectra at different times for a comparative ink containing cyclohexylbenzene and a phenylimidazole emitter;
Figure 3 illustrates the LCMS spectrum of a comparative ink containing cyclohexylbenzene and a phenyltriazole emitter after 1 day;

### Detailed Description of the Invention

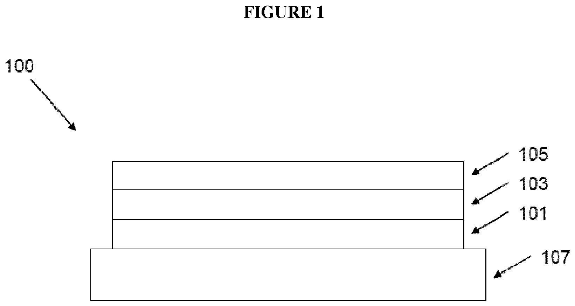

Figure 1, which is not drawn to any scale, illustrates an OLED 100 according to an embodiment of the invention supported on a substrate 101, for example a glass or plastic substrate. The OLED 100 comprises an anode 103, a light-emitting layer 105 and a cathode 107.

Light-emitting layer 105 comprises a phosphorescent light-emitting material of formula (I) and may comprise one or more further light-emitting materials. Preferably, light-emitting layer 105 comprises at least one further light-emitting material that produces light during operation of the device 100. Preferably, any further light-emitting material of the light-emitting layer 105 is a phosphorescent material.

The phosphorescent material of formula (I) of the light-emitting layer 105 and, if present, any further phosphorescent materials of this layer, may be doped in a host material. The lowest excited state triplet energy (T₁) level of the host material is preferably no more than 0.1 eV below that of the phosphorescent light-emitting material of formula (I), and is more preferably about the same or higher than that of the phosphorescent light-emitting material of formula (I) in order to avoid quenching of phosphorescence.

One or more further layers may be provided between the anode 103 and cathode 107, for example hole-transporting layers, electron transporting layers, hole blocking layers and electron blocking layers. The device may contain more than one light-emitting layer.

Preferred device structures include:
Anode / Hole-injection layer / Light-emitting layer / Cathode
Anode / Hole transporting layer / Light-emitting layer / Cathode
Anode / Hole-injection layer / Hole-transporting layer / Light-emitting layer / Cathode
Anode / Hole-injection layer / Hole-transporting layer / Light-emitting layer / Electron-transporting layer / Cathode.

Preferably, at least one of a hole-transporting layer and a hole injection layer is present. Preferably, both a hole injection layer and a hole-transporting layer are present.

The light-emitting layer 105 is deposited by solution processing an ink comprising a phosphorescent compound, a first solvent and a stabiliser, followed by evaporation of the first solvent, the stabiliser and any other solvents present in the ink.

The ink may contain one or more further components that form part of the light-emitting layer, for example one or more further light-emitting materials and one or more host materials.

Preferably, the components of the light-emitting layer are provided in an amount of 0.1-5 wt % of the solvent or solvents of the ink, optionally 1-5 wt %, optionally 1-3 wt %.

The viscosity of the ink is selected according to the solution processing method to be used. For ink-jet printing, the ink preferably has a viscosity of less than 15 cP, preferably less than 10 cP and preferably greater than 2 cP at room temperature..For slot die coating, the ink preferably has a viscosity of greater than 2 cP at room temperature.

### First phosphorescent material

Preferably, the first phosphorescent material has formula (I): 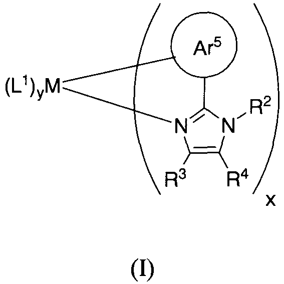 wherein:
Ar⁵ is an aryl or heteroaryl group that may be unsubstituted or substituted with one or more substituents;
R² is a substituent;
each R³ is independently H or R²;
each R⁴ is independent H or R²;
M is a transition metal or metal ion;
x is a positive integer of at least 1;
y is 0 or a positive integer; and
each L¹ is independently a mono- or polydentate ligand different from ligands of formula

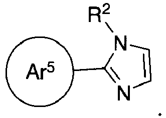

Optionally, substituents R² are selected from:
- alkyl, optionally C₁₋₂₀ alkyl, wherein one or more non-adjacent C atoms of the alkyl may be replaced with unsubstituted or substituted aryl or heteroaryl, O, S, NR⁵, C=O or - COO- wherein R⁵ is a substituent, optionally C₁₋₂₀ hydrocarbyl, and one or more H atoms of the alkyl may be replaced with F; and
- (Ar⁹)_{w} wherein Ar⁹ is independently in each occurrence an aryl or heteroaryl group, optionally an aryl group, optionally phenyl, that may be unsubstituted or substituted with one or more substituents, and w is at least 1, optionally 1, 2 or 3

Substituents for groups Ar⁹ may be selected from F; CN; NO₂; and C₁₋₂₀ alkyl wherein one or more non-adjacent carbon atoms may be replaced with O, S, NR⁵, C=O or -COO-, and one or more H atoms may be replaced with F, wherein R⁵ is substituent, optionally a C₁₋₄₀ hydrocarbyl group, optionally a group selected from C₁₋₂₀ alkyl and phenyl that may be unsubstituted or substituted with one or more C₁₋₂₀ alkyl groups Preferably, each R² is independently a C₁₋₄₀ hydrocarbyl group, more preferably C₁₋₂₀ alkyl or a C₁₋₄₀ hydrocarbyl group of formula -(Ar⁹)_{w} wherein each Ar⁹ group is independently unsubstituted or substituted with one or more C₁₋₂₀ alkyl groups.

Preferably, Ar⁵ is phenyl that may be unsubstituted or substituted with one or more substituents.

The or each substituent of Ar⁵, if present, may independently in each occurrence be selected from substituents R² described above, more preferably selected from a C₁₋₄₀ hydrocarbyl group, more preferably a C₁₋₄₀ hydrocarbyl group.

Preferably, R³ is H or a C₁₋₄₀ hydrocarbyl group as described with reference to R².

Preferably, R⁴ is H or a C₁₋₄₀ hydrocarbyl group as described with reference to R². More preferably, R⁴ is H.

M of compounds of formula (I) may be selected from heavy metal transition metal complexes, optionally ruthenium, rhodium, palladium, rhenium, osmium, iridium, platinum and gold. Iridium is particularly preferred.

In one optional arrangement, x is 3 and y is 0.

In another optional arrangement, y is a positive integer, optionally 1 or 2, and each L¹ is independently a monodentate or polydentate ligand. Exemplary ligands L¹ include tetrakis-(pyrazol-1-yl)borate, 2-carboxypyridyl and diketonates, for example acetylacetonate.

Exemplary compounds of formula (I) are illustrated below:

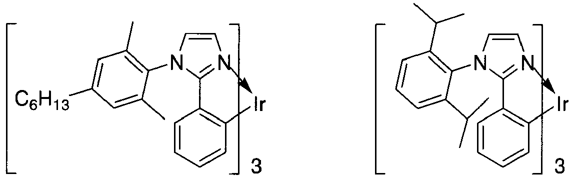

Preferably, the first phosphorescent compound emits blue light. A blue emitting material may have a photoluminescent spectrum with a peak in the range of no more than 490 nm, optionally in the range of 420-480 nm.

The ink may contain one or more further light-emitting materials, preferably one or more further phosphorescent materials. Optionally, the further light-emitting material or materials emit green or red light.

A green emitting material may have a photoluminescent spectrum with a peak in the range of more than 490nm up to 580 nm, optionally more than 490 nm up to 540 nm.

A red emitting material may optionally have a peak in its photoluminescent spectrum of more than 580 nm up to 630 nm, optionally 585-625 nm.

The photoluminescence spectrum of a light-emitting material may be measured by casting 5 wt % of the material in a PMMA film onto a quartz substrate to achieve transmittance values of 0.3-0.4 and measuring the spectrum in a nitrogen environment using apparatus C9920-02 supplied by Hamamatsu.

### Host

Preferably, the ink comprises a host material. The host material may be a polymeric or non-polymeric material. Preferably, the host is non-polymeric.

The host material preferably has a lowest excited state triplet energy level that is the same as or higher than the lowest excited state triplet energy level of the first phosphorescent compound.

Exemplary non-polymeric hosts have formula (XV): 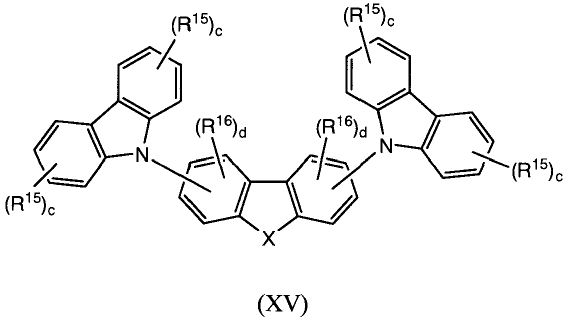 wherein each R¹⁵ and R¹⁶ is independently a substituent; X is O or S; each c is independently 0, 1, 2, 3 or 4; and each d is independently 0, 1, 2 or 3.

The host of formula (XV) may have formula (XVa): 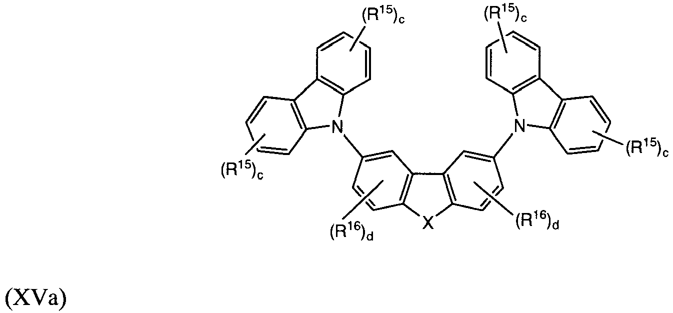
Each R¹⁵ and R¹⁶, where present, may independently in each occurrence be selected from the group consisting of alkyl, optionally C₁₋₂₀ alkyl, wherein one or more non-adjacent C atoms may be replaced with optionally substituted aryl or heteroaryl, O, S, substituted N, C=O or -COO-, and one or more H atoms may be replaced with F; aryl and heteroaryl groups that may be unsubstituted or substituted with one or more substituents; and a branched or linear chain of aryl or heteroaryl groups. Exemplary aryl or heteroaryl groups are unsubstituted phenyl and phenyl substituted with one or more C₁₋₂₀ alkyl groups; F; CN and NO₂.
X is preferably S.

Host polymers include polymers having a non-conjugated backbone with charge-transporting groups pendant from the polymer backbone, and polymers having a conjugated backbone in which adjacent repeat units of the polymer backbone are conjugated together. A conjugated host polymer may comprise, without limitation, repeat units selected from optionally substituted arylene or heteroarylene repeat units.

Exemplary arylene repeat units include, without limitation, fluorene, phenylene, phenanthrene naphthalene and anthracene repeat units, each of which may independently be unsubstituted or substituted with one or more substituents, optionally one or more C₁₋₄₀ hydrocarbyl substituents.

The host polymer may contain triazine-containing repeat units. Exemplary triazine-containing repeat units have formula (IV): 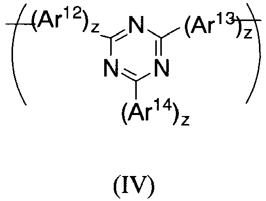 wherein Ar¹², Ar¹³ and Ar¹⁴ are independently selected from substituted or unsubstituted aryl or heteroaryl, and z in each occurrence is independently at least 1, optionally 1, 2 or 3, preferably 1.

Polymers comprising repeat units of formula (IV) may be copolymers comprising repeat units of formula (IV) and one or more co-repeat units, and may comprise repeat units of formula (IV) and one or more arylene repeat units as described above.

Any of Ar¹², Ar¹³ and Ar¹⁴ may be substituted with one or more substituents. Exemplary substituents are substituents R¹⁰, wherein each R¹⁰ may independently be selected from the group consisting of:
- substituted or unsubstituted alkyl, optionally C₁₋₂₀ alkyl, wherein one or more non-adjacent C atoms may be replaced with optionally substituted aryl or heteroaryl, O, S, substituted N, C=O or -COO- and one or more H atoms may be replaced with F; and
- a crosslinkable group attached directly to Ar¹², Ar¹³ and Ar¹⁴ or spaced apart therefrom by a spacer group, for example a group comprising a double bond such and a vinyl or acrylate group, or a benzocyclobutane group.

Substituted N, where present, may be -NR¹⁷- wherein R¹⁷ is a substituent, optionally a C₁₋₂₀ hydrocarbyl group.

Preferably, Ar¹², Ar¹³ and Ar¹⁴ of formula (IV) are each phenyl, each phenyl independently being unsubstituted or substituted with one or more C₁₋₂₀ alkyl groups. Ar¹⁴ of formula (IV) is preferably phenyl, and is optionally substituted with one or more C₁₋₂₀ alkyl groups or a crosslinkable unit.

A particularly preferred repeat unit of formula (IV) has formula (IVa).

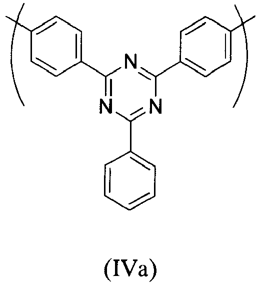

The phenyl groups of the repeat unit of formula (IVa) may each independently be unsubstituted or substituted with one or more substituents R¹⁰ as described above with respect to formula (IV), preferably one or more C₁₋₂₀ alkyl groups.

The compound of formula (I) and / or any other phosphorescent material of light-emitting layer 105, may be blended with or covalently bound to a host polymer.

The first phosphorescent material, and / or another phosphorescent material of the ink, if present, may be covalently bound to a host polymer as a repeat unit in the polymer backbone, as an end-group of the polymer, or as a side-chain of the polymer. If the phosphorescent material is provided in a side-chain then it may be directly bound to a repeat unit in the backbone of the polymer or it may be spaced apart from the polymer backbone by a spacer group. Exemplary spacer groups include C₁₋₂₀ alkyl and aryl-C₁₋₂₀ alkyl, for example phenyl-C₁₋₂₀ alkyl. One or more carbon atoms of an alkyl group of a spacer group may be replaced with O, S, C=O or COO.

The first phosphorescent compound mixed with a host material may form 0.1 - 50 weight %, optionally 0.1 - 40 weight % of the weight of the components of the layer containing the phosphorescent material.

If the first phosphorescent compound is covalently bound to a host polymer then repeat units comprising the phosphorescent material, or an end unit comprising the phosphorescent material, may form 0.1-20 mol of the polymer.

If two or more phosphorescent materials are provided in light-emitting layer 105 then the phosphorescent material with the highest triplet energy level is preferably provided in a larger weight percentage than the lower triplet energy level phosphorescent material or materials.

### Solvents

The ink may comprise one or more first solvents selected from:
(i) Linear, branched or cyclic ether comprising one or more O-CH₂- units, for example diethyl ether, tetrahydrofuran, dioxane and diglyme;
(ii) Solvents comprising a CH₂-C(R⁶)H-CH₂ unit wherein R⁶ is an organic residue and the two CH₂ groups may be linked by a divalent group.

Optionally, R⁶ is a C₁₋₃₀ hydrocarbyl group, optionally phenyl that may be unsubstituted or substituted with one or more C₁₋₁₀ alkyl groups.

Optionally, the two CH₂ groups may be linked by ethylene or propylene.

Optionally, the solvent has formula CH₃-C(R⁶)H-CH₃.

Exemplary solvents comprising a CH₂-C(R⁶)H-CH₂ unit are cyclohexylbenzene and cumene.
(iii) Bicyclic, partially or fully saturated solvents, optionally solvents comprising a secondary carbon atom, optionally partially or fully saturated naphthalenes, for example tetralin and decalin.
(iv) Solvents of formula R⁸-CR⁷=CR⁷-CH₂- R⁸ wherein R⁷ is H or C₁₋₁₀ alkyl; and R⁸ in each occurrence is independently an organic residue, optionally a C₁₋₂₀ hydrocarbyl group.
(v) Solvents comprising a benzyl group.

Optionally, the or each first solvent consists of 4-20 carbon atoms, optionally 10-20 C atoms, and 0, 1, 2 or 3 oxygen atoms only.

Preferably, the solvent is a liquid at 20°C and has a boiling point of below 300°C, optionally no more than 250°C, at 1 atmosphere.

Preferably, the first solvent is cyclohexylbenzene. The ink may contain one or more further solvents that are miscible with the one or more first solvents. Exemplary further solvents may be selected from benzene substituted with one or more substituents selected from straight chain or branched C₁₋₁₀ alkyl or alkoxy groups.

Without wishing to be bound by any theory, it is believed that first solvents as described herein may be susceptible to oxidation, and that oxidised first solvents may react with the compounds of formula (I).

### Stabiliser

Optionally, the stabiliser is an antioxidant. Without wishing to be bound by any theory, antioxidant stabilisers may prevent oxidation of the first solvent.

Optionally, the stabiliser is a phenol wherein one or more C atoms of the phenol are unsubstituted or substituted with one or more substituents, preferably one or more substituents selected from C₁₋₁₀ alkyl groups; C₁₋₁₀ alkoxy groups; and hydroxyl groups.

Optionally, the stabiliser is an arylamine (primary amine) or diarylamine (secondary amine) wherein the or each aryl group may be unsubstituted or substituted with one or more substituents, optionally one or more substituents selected from C₁₋₁₀ alkyl groups; C₁₋₁₀ alkoxy groups; and hydroxyl groups. Optionally, the or each aryl group is phenyl.

Exemplary stabilisers are butylated hydroxytoluene; polyhydroxyphenols; hydroquinone; aminophenols; and diphenylamine.

Preferably, the stabiliser is butylated hydroxytoluene (BHT):

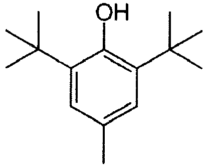

Optionally, the stabiliser is provided in an amount in the range of 0.5-100 mg per 100 ml of ink, optionally 1-50 or 5-20 mg per 100 ml of ink.

### Inkjet printing

A device may be inkjet printed by providing a patterned insulating layer over the anode to define wells for printing of one colour (in the case of a monochrome device) or multiple colours (in the case of a multicolour, in particular full colour device). The patterned layer is typically a layer of photoresist that is patterned to define wells as described in, for example, EP 0880303.

As an alternative to wells, the ink may be printed into channels defined within a patterned layer. In particular, the insulating layer may be patterned to form channels which, unlike wells, extend over a plurality of pixels and which may be closed or open at the channel ends.

Other solution deposition techniques include spin-coating, slot die coating, dip-coating, flexographic printing, nozzle printing, and screen printing.

### Charge transporting and charge blocking layers

A hole transporting layer may be provided between the anode 103 and the light-emitting layer 105.

An electron transporting layer may be provided between the cathode 107 and the light-emitting layer 105.

A charge-transporting layer or charge-blocking layer may be cross-linked. The crosslinkable group used for this crosslinking may be a crosslinkable group comprising a reactive double bond such and a vinyl or acrylate group, or a benzocyclobutane group. Crosslinking may be performed by thermal treatment, preferably at a temperature of less than about 250°C, optionally in the range of about 100-250°C.

A hole transporting layer may comprise or may consist of a hole-transporting polymer, which may be a homopolymer or copolymer comprising two or more different repeat units. The hole-transporting polymer may be conjugated or non-conjugated. Exemplary conjugated hole-transporting polymers are polymers comprising arylamine repeat units, for example as described in WO 99/54385 or WO 2005/049546 the contents of which are incorporated herein by reference. Conjugated hole-transporting copolymers comprising arylamine repeat units may have one or more co-repeat units selected from arylene repeat units, for example one or more repeat units selected from fluorene, phenylene, phenanthrene naphthalene and anthracene repeat units, each of which may independently be unsubstituted or substituted with one or more substituents, optionally one or more C₁₋₄₀ hydrocarbyl substituents.

If present, a hole transporting layer located between the anode and the light-emitting layer 105 preferably has a HOMO level of less than or equal to 5.5 eV, more preferably around 4.8-5.5 eV or 5.1-5.3 eV as measured by cyclic voltammetry. The HOMO level of the hole transport layer may be selected so as to be within 0.2 eV, optionally within 0.1 eV, of an adjacent layer (such as a light-emitting layer) in order to provide a small barrier to hole transport between these layers.

Preferably a hole-transporting layer, more preferably a crosslinked hole-transporting layer, is adjacent to the light-emitting layer containing the compound of formula (I).

A hole-transporting layer may consist essentially of a hole-transporting material or may comprise one or more further materials. A light-emitting material, optionally a phosphorescent material, may be provided in the hole-transporting layer. A light-emitting material may be blended with or covalently bound to the hole-transporting material.

The light-emitting layer 105 may be adjacent to the cathode 107. In other embodiments, an electron-transporting layer may be provided between the light-emitting layer 105 and the cathode 107.

If present, an electron transporting layer located between the light-emitting layer and cathode preferably has a LUMO level of around 1.8-2.7 eV as measured by square wave voltammetry. An electron-transporting layer may have a thickness in the range of about 5-50 nm, optionally 5-20 nm.

Electron-transporting materials for forming an electron-transporting layer may be non-polymeric or polymeric compounds and may be deposited from a solution in a solvent that the components of the light-emitting layer 105 are substantially insoluble in. The electron transporting materials may be substituted with polar groups and may be soluble in polar solvents.

Exemplary electron transporting polymers suitable for forming an electron-transporting layer are described in WO 2012/133229, the contents of which are incorporated herein by reference.

### Hole injection layers

A conductive hole injection layer, which may be formed from a conductive organic or inorganic material, may be provided between the anode 103 and the light-emitting layer 105 of an OLED as illustrated in Figure 1 to assist hole injection from the anode into the layer or layers of semiconducting polymer. Examples of doped organic hole injection materials include optionally substituted, doped poly(ethylene dioxythiophene) (PEDT), in particular PEDT doped with a charge-balancing polyacid such as polystyrene sulfonate (PSS) as disclosed in EP 0901176 and EP 0947123, polyacrylic acid or a fluorinated sulfonic acid, for example Nafion ®; polyaniline as disclosed in US 5723873 and US 5798170; and optionally substituted polythiophene or poly(thienothiophene). Examples of conductive inorganic materials include transition metal oxides such as VOx MoOx and RuOx as disclosed in Journal of Physics D: Applied Physics (1996), 29(11), 2750-2753.

### Cathode

The cathode 107 is selected from materials that have a work function allowing injection of electrons into the light-emitting layer of the OLED. Other factors influence the selection of the cathode such as the possibility of adverse interactions between the cathode and the light-emitting material. The cathode may consist of a single material such as a layer of aluminium. Alternatively, it may comprise a plurality of conductive materials such as metals, for example a bilayer of a low work function material and a high work function material such as calcium and aluminium, for example as disclosed in WO 98/10621. The cathode may comprise elemental barium, for example as disclosed in WO 98/57381, Appl. Phys. Lett. 2002, 81(4), 634 and WO 02/84759. The cathode may comprise a thin (e.g. 0.5-5 nm) layer of metal compound, in particular an oxide or fluoride of an alkali or alkali earth metal, between the organic layers of the device and one or more conductive cathode layers to assist electron injection, for example lithium fluoride as disclosed in WO 00/48258; sodium fluoride; barium fluoride as disclosed in Appl. Phys. Lett. 2001, 79(5), 2001; and barium oxide. In order to provide efficient injection of electrons into the device, the cathode preferably has a workfunction of less than 3.5 eV, more preferably less than 3.2 eV, most preferably less than 3 eV. Work functions of metals can be found in, for example, Michaelson, J. Appl. Phys. 48(11), 4729,1977.

The cathode may be opaque or transparent. Transparent cathodes are particularly advantageous for active matrix devices because emission through a transparent anode in such devices is at least partially blocked by drive circuitry located underneath the emissive pixels. A transparent cathode comprises a layer of an electron injecting material that is sufficiently thin to be transparent. Typically, the lateral conductivity of this layer will be low as a result of its thinness. In this case, the layer of electron injecting material is used in combination with a thicker layer of transparent conducting material such as indium tin oxide.

It will be appreciated that a transparent cathode device need not have a transparent anode (unless a fully transparent device is desired), and so the transparent anode used for bottom-emitting devices may be replaced or supplemented with a layer of reflective material such as a layer of aluminium. Examples of transparent cathode devices are disclosed in, for example, GB 2348316.

### Encapsulation

Organic optoelectronic devices tend to be sensitive to moisture and oxygen. Accordingly, the substrate 101 preferably has good barrier properties for prevention of ingress of moisture and oxygen into the device. The substrate is commonly glass, however alternative substrates may be used, in particular where flexibility of the device is desirable. For example, the substrate may comprise one or more plastic layers, for example a substrate of alternating plastic and dielectric barrier layers or a laminate of thin glass and plastic.

The device may be encapsulated with an encapsulant (not shown) to prevent ingress of moisture and oxygen. Suitable encapsulants include a sheet of glass, films having suitable barrier properties such as silicon dioxide, silicon monoxide, silicon nitride or alternating stacks of polymer and dielectric or an airtight container. In the case of a transparent cathode device, a transparent encapsulating layer such as silicon monoxide or silicon dioxide may be deposited to micron levels of thickness, although in one preferred embodiment the thickness of such a layer is in the range of 20-300 nm. A getter material for absorption of any atmospheric moisture and / or oxygen that may permeate through the substrate or encapsulant may be disposed between the substrate and the encapsulant.

### Examples

### Ink stability

Inks were prepared as set out in Table 1.

**Table 1**

| **Ink** | **Solvent** | **Emitter** |
|---|---|---|
| Comparative Ink 1 | Cyclohexylbenzene | Blue Emitter 1 |
| Comparative Ink 2 | Cyclohexylbenzene | Blue Emitter 2 |
| Comparative Ink 3 | Cyclohexylbenzene | Blue Emitter 3 |

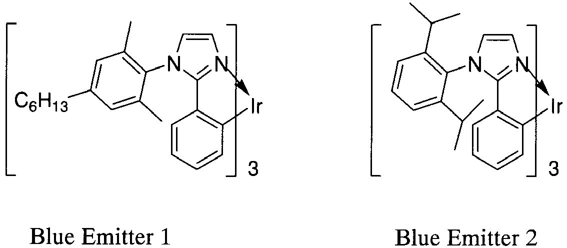

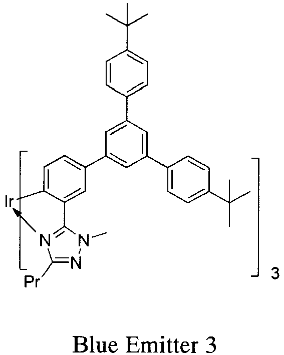

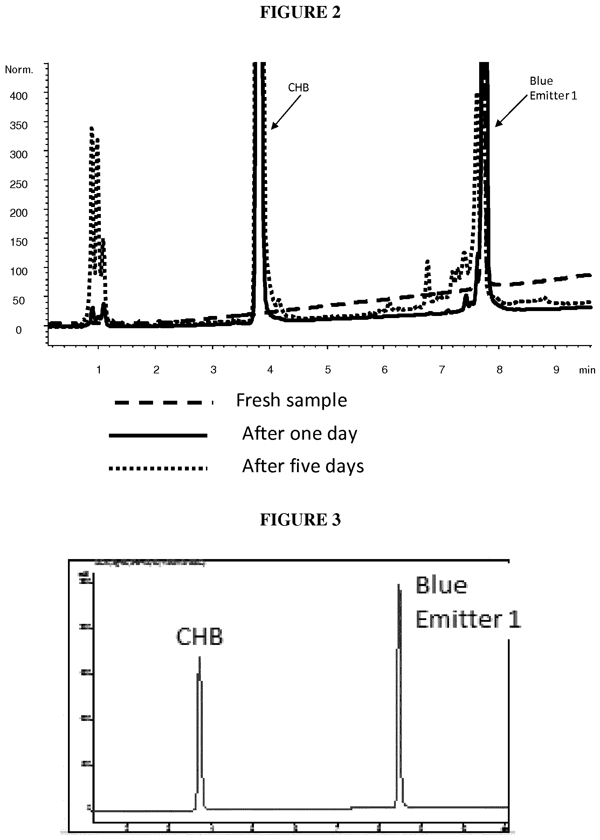

Comparative Inks 1 and 2 of a phenylimidazole emitter dissolved in cyclohexylbenzene were found to undergo a colour change over a period of 24 hours, indicating degradation of the ink. Figure 2 shows changes in the LCMS spectra of Comparative Ink 1 over a period of 5 days, indicating formation of degradation products over this period.

In contrast Figure 3 shows no signs of degradation after 1 day for Comparative Ink 3, which contains cyclohexylbenzene with a phenyltriazole emitter.

### White Device Example 1

A white organic light-emitting device having the following structure was prepared:
ITO (45 nm) / HIL (65 nm) / LE (R) (22 nm) / LE (G, B) (75 nm) / Cathode
wherein ITO is an indium-tin oxide anode; HIL is a hole-injecting layer; LE (R) is a red light-emitting layer; LE (G, B) is a green and blue light-emitting layer; ETL is a electron-transporting layer; and the cathode comprises a layer of sodium fluoride in contact with the light-emitting layer, a layer of aluminium and a layer of silver.

To form the device, a substrate carrying ITO was cleaned using UV / Ozone. The hole injection layer was formed by spin-coating an aqueous formulation of a hole-injection material from Plextronics, Inc. and heating the resultant layer. The red light-emitting layer was formed by spin-coating Red Polymer 1 and crosslinking the polymer by heating. The green and blue light-emitting layer was formed by spin-coating an ink of containing 2 wt % of Host 1 (74 wt%), Green Emitter 1 (1 wt%) and Blue Emitter 1 (25 wt%) dissolved in cyclohexylbenzene and containing 12.5 mg of BHT per 100 ml of ink. The cathode was formed by evaporation of a first layer of sodium fluoride to a thickness of about 2 nm, a second layer of aluminium to a thickness of about 100 nm and a third layer of silver to a thickness of about 100 nm.

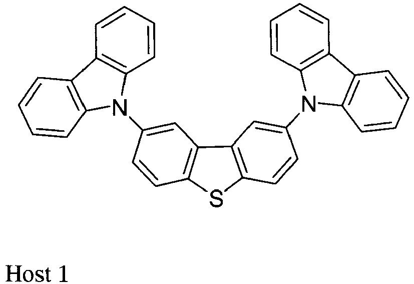

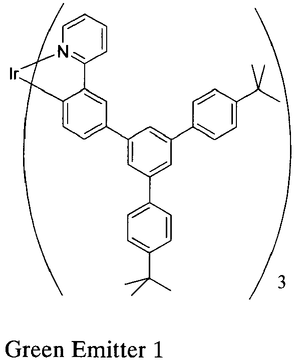

Red Polymer 1 was formed by Suzuki polymerisation as described in WO 00/53656 of monomers for forming a phenylene repeat unit, an amine repeat unit and a fluorene repeat unit substituted with crosslinkable group. The polymer was end-capped with a red-emitting end-capping group of formula:

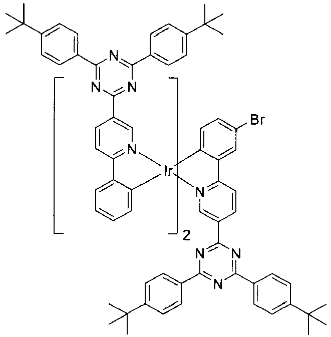

### Comparative Device 1

A device was prepared as described for White Device Example 1 except toluene was used in place of cyclohexylbenzene and BHT stabiliser was not included in the ink.

### Comparative Device 2

A device was prepared as described for White Device Example 1 except that BHT stabiliser was not included in the ink.

### Device results

In contrast to Comparative Inks 1 and 2 that do not contain a stabiliser, the ink used in White Device Example 1 did not change colour indicating stabilisation by BHT.

The toluene-based ink used in formation of Comparative Device 1 did not show a colour change indicating that little or no degradation of this ink occurs.

Devices were tested at a brightness of 1000 cd/m². Attempts to test Comparative Device 2 at this brightness failed due to degradation of the device at this brightness. Without wishing to be bound by any theory, it is believed that the poor performance of Comparative Device 2 is due to degradation of the materials in the ink used in manufacture of this device.

Data for White Device Example 1 and Comparative Device 1 are provided in Table 2. Performance of the devices is similar. Without wishing to be bound by any theory, it is believed that degradation of the cyclohexylbenzene ink of Comparative Device 2 has is at least partially eliminated by the presence of the stabiliser.

| Device | Voltage | Current | Efficiency Lm/W | Efficiency cd/A | Quantum Efficiency | LT (h) |
|---|---|---|---|---|---|---|
| Comparative Device 1 | 8.8 | 3.1 | 11.4 | 32.1 | 13.53 | 44 |
| Device Example 1 | 8.2 | 3.7 | 10.3 | 26.9 | 11.60 | 35 |

Although the present invention has been described in terms of specific exemplary embodiments, it will be appreciated that various modifications, alterations and/or combinations of features disclosed herein will be apparent to those skilled in the art without departing from the scope of the invention as set forth in the following claims.

## Claims

1. An ink comprising a first solvent, an antioxidant and a first phosphorescent metal complex wherein the first phosphorescent metal complex comprises at least one aryl-imidazole or heteroaryl-imidazole ligand that may be unsubstituted or substituted with one or more substituents.

2. The ink according to claim 1 wherein the first solvent is selected from:
linear, branched or cyclic ethers comprising one or more O-CH₂ units;
solvents comprising a CH₂-C(R⁶)H-CH₂ unit wherein R⁶ is an organic residue and the two CH₂ groups may be linked by a divalent group: bicyclic, partially or fully saturated solvents; solvents of formula R⁸-CR⁷=CR⁷-CH²-R⁸ wherein each R⁷ is independently H or C₁₋₁₀ alkyl and R⁸ in each occurrence is independently an organic residue; and solvents comprising a benzyl group.

3. The ink according to claim 2 wherein the first phosphorescent light-emitting material is an iridium complex.

4. The ink according to claim 2 or 3 wherein the aryl-imidazole or heteroaryl-imidazole ligand is a phenyl imidazole ligand.

5. The ink according to any one of claims 2 to 4 wherein the first solvent is cyclohexylbenzene.

6. The ink according to any one of claims 2 to 5 wherein the antioxidant has a boiling point below 300°C.

7. The ink according to any one of claims 2 to 6 wherein the antioxidant is selected from a phenol wherein one or more C atoms of the phenol are unsubstituted or substituted with one or more substituents and an arylamine or diarylamine wherein the or each aryl group may be unsubstituted or substituted with one or more substituents.

8. The ink according to any one of claims 2 to 7 wherein the antioxidant is butylhydxoxytoluene.

9. The ink according to any one of claims 2 to 8 comprising a host material.

10. The ink according to any one of claims 2 to 9 wherein the ink does not contain any polymers.

11. The ink according to any one of claims 2 to 10 having a viscosity greater than 2 cP at room temperature.

12. The ink according to any one of claims 2 to 11 wherein the antioxidant is present in an amount in the range of 0.5-100 mg per 100 ml of ink.

13. The ink according to any one of claims 2 to 12 wherein the first phosphorescent light-emitting material is present in an amount of 0.1-5 wt % of the solvent or solvents of the ink.

14. A method of forming an organic light-emitting device comprising an anode, a cathode and a light-emitting layer between the anode and cathode, the method comprising the steps of forming the light-emitting layer by depositing an ink composition according to any one of claims 2 to 13 over one of the anode and cathode; evaporating the or each solvent and the antioxidant; and forming the other of the anode and cathode over the light-emitting layer.

## Patentansprüche

1. Tinte, umfassend ein erstes Lösungsmittel, ein Antioxidans und einen ersten phosphoreszierende Metallkomplex, wobei der erste phosphoreszierenden Metallkomplex mindestens einen Arylimidazol- oder Heteroarylimidazol-Liganden, der unsubstituiert oder durch einen oder mehrere Substituenten substituiert sein kann, umfasst.

2. Tinte nach Anspruch 1, wobei das erste Lösungsmittel aus linearen, verzweigten oder cyclischen Ethern mit einer oder mehreren O-CH₂-Einheiten; Lösungsmitteln mit einer CH₂-C(R⁶)H-CH₂-Einheit, wobei R⁶ für einen organischen Rest steht und die beiden CH₂-Gruppen über eine zweiwertige Gruppe verknüpft sein können; bicyclischen, teilweise oder vollständig gesättigten Lösungsmitteln; Lösungsmitteln der Formel R⁸-CR⁷=CR⁷-CH₂-R⁸, wobei R⁷ jeweils unabhängig für H oder C₁₋₁₀-Alkyl steht und R⁸ bei jedem Auftreten unabhängig für einen organischen Rest steht; und Lösungsmitteln mit einer Benzylgruppe ausgewählt ist.

3. Tinte nach Anspruch 2, wobei es sich bei dem ersten phosphoreszierenden lichtemittierenden Material um einen Iridiumkomplex handelt.

4. Tinte nach Anspruch 2 oder 3, wobei es sich bei dem Arylimidazol- oder Heteroarylimidazol-Liganden um einen Phenylimidazol-Liganden handelt.

5. Tinte nach einem der Ansprüche 2 bis 4, wobei es sich bei dem ersten Lösungsmittel um Cyclohexylbenzol handelt.

6. Tinte nach einem der Ansprüche 2 bis 5, wobei das Antioxidans einen Siedepunkt von weniger als 300 °C aufweist.

7. Tinte nach einem der Ansprüche 2 bis 6, wobei das Antioxidans aus einem Phenol, wobei ein oder mehrere C-Atome des Phenols unsubstituiert oder durch einen oder mehrere Substituenten substituiert sind, und einem Arylamin oder Diarylamin, wobei die bzw. jede Arylgruppe unsubstituiert oder durch einen oder mehrere Substituenten substituiert sein kann, ausgewählt ist.

8. Tinte nach einem der Ansprüche 2 bis 7, wobei es sich bei dem Antioxidans um Butylhydroxytoluol handelt.

9. Tinte nach einem der Ansprüche 2 bis 8, umfassend ein Wirtsmaterial.

10. Tinte nach einem der Ansprüche 2 bis 9, wobei die Tinte keine Polymere enthält.

11. Tinte nach einem der Ansprüche 2 bis 10 mit einer Viskosität von mehr als 2 cP bei Raumtemperatur.

12. Tinte nach einem der Ansprüche 2 bis 11, wobei das Antioxidans in einer Menge im Bereich von 0,5-100 mg pro 100 ml Tinte vorliegt.

13. Tinte nach einem der Ansprüche 2 bis 12, wobei das erste phosphoreszierende lichtemittierende Material in einer Menge von 0,1-5 Gew.-% des Lösungsmittels bzw. der Lösungsmittel der Tinte vorliegt.

14. Verfahren zum Bilden einer organischen lichtemittierenden Vorrichtung mit einer Anode, einer Kathode und einer lichtemittierenden Schicht zwischen der Anode und der Kathode, bei dem man durch Abscheiden einer Tintenzusammensetzung nach einem der Ansprüche 2 bis 13 auf der Anode oder der Kathode die lichtemittierende Schicht bildet, das bzw. jedes Lösungsmittel und das Antioxidans verdampft und über der lichtemittierenden Schicht das jeweils andere Element - die Anode oder die Kathode - bildet.

## Revendications

1. Encre comprenant un premier solvant, un antioxydant et un premier complexe métallique phosphorescent, dans laquelle le premier complexe métallique phosphorescent comprend au moins un ligand arylimidazole ou hétéroarylimidazole qui peut être non substitué ou substitué par un ou plusieurs substituants.

2. Encre selon la revendication 1 dans laquelle le premier solvant est choisi parmi : les éthers linéaires, ramifiés ou cycliques comprenant un ou plusieurs motifs O-CH₂ ; les solvants comprenant un motif CH₂-C(R⁶)H-CH₂, R⁶ étant un résidu organique et les deux groupes CH₂ pouvant être reliés par un groupe divalent ; les solvants bicycliques partiellement ou complètement saturés ; les solvants de formule R⁸-CR⁷=CR⁷-CH₂-R⁸, chaque R⁷ étant indépendamment H ou un groupe alkyle en C₁₋₁₀ et R⁸ à chaque occurrence étant indépendamment un résidu organique ; et les solvants comprenant un groupe benzyle.

3. Encre selon la revendication 2 dans laquelle la première substance électroluminescente phosphorescente est un complexe de l'iridium.

4. Encre selon la revendication 2 ou 3 dans laquelle le ligand arylimidazole ou hétéroarylimidazole est un ligand phénylimidazole.

5. Encre selon l'une quelconque des revendications 2 à 4 dans laquelle le premier solvant est le cyclohexylbenzène.

6. Encre selon l'une quelconque des revendications 2 à 5 dans laquelle l'antioxydant a un point d'ébullition au-dessous de 300 °C.

7. Encre selon l'une quelconque des revendications 2 à 6 dans laquelle l'antioxydant est choisi entre un phénol, un ou plusieurs atomes de C du phénol étant non substitués ou substitués par un ou plusieurs substituants, et une arylamine ou diarylamine, le groupe aryle ou chaque groupe aryle pouvant être non substitué ou substitué par un ou plusieurs substituants.

8. Encre selon l'une quelconque des revendications 2 à 7 dans laquelle l'antioxydant est le butylhydroxytoluène.

9. Encre selon l'une quelconque des revendications 2 à 8 comprenant une substance hôte.

10. Encre selon l'une quelconque des revendications 2 à 9, l'encre ne contenant pas de quelconques polymères.

11. Encre selon l'une quelconque des revendications 2 à 10 ayant une viscosité supérieure à 2 cP à température ambiante.

12. Encre selon l'une quelconque des revendications 2 à 11 dans laquelle l'antioxydant est présent en une quantité dans la plage de 0,5-100 mg pour 100 ml d'encre.

13. Encre selon l'une quelconque des revendications 2 à 12 dans laquelle la première substance électroluminescente phosphorescente est présente en une quantité de 0,1-5 % en poids du ou des solvants de l'encre.

14. Procédé de formation d'un dispositif électroluminescent organique comprenant une anode, une cathode et une couche électroluminescente entre l'anode et la cathode, le procédé comprenant les étapes consistant à former la couche électroluminescente par dépôt d'une composition d'encre selon l'une quelconque des revendications 2 à 13 sur l'une de l'anode et de la cathode ; faire évaporer le solvant ou chaque solvant et l'antioxydant ; et former l'autre de l'anode et de la cathode sur la couche électroluminescente.
